# EUROPÄISCHE PATENTSCHRIFT

(11) **EP 1 256 636 B1**
(45) Veröffentlichungstag und Bekanntmachung des Hinweises auf die Patenterteilung: **21.06.2006**
(21) Anmeldenummer: 02009402.5
(22) Anmeldetag: 25.04.2002
(51) Int. Cl.: C23C 14/08, C23C 14/30, C23C 30/00, C01F 17/00, C23C 26/00

(54) **Wärmedämmmaterial mit im wesentlichen magnetoplumbitischer Kristallstruktur**
Thermal insulating material with an essentially magnetoplumbitic crystal structure
Materiau thermo-isolant avec une structure cristalline essentiellement magnétoplumbitique

(30) Priorität: 09.05.2001 DE 10122545
(43) Veröffentlichungstag der Anmeldung: 13.11.2002
(73) Patentinhaber: Deutsches Zentrum für Luft- und Raumfahrt e.V., 51147 Köln (DE)
(72) Erfinder: Saruhan-Brings, Bilge, Dr., 53844 Troisdorf (DE); Schulz, Uwe, Dr., 53819 Neunkirchen-Seelscheid (DE); Kröder, Claus-Jürgen, 53757 St. Augustin (DE)
(74) Vertreter: Jönsson, Hans-Peter

(56) Entgegenhaltungen:
- DE-C- 19 807 163
- US-A- 4 542 111
- FRIEDRICH ET AL.: "Lanthanum hexaaluminate thermal barrier coatings" CERAM. ENG. SCI. PROC. (USA), 2001, Bd. 22, Nr. 4, 21. - 27. Januar 2001, Seiten 375-382, XP009007230
- MARTINAT ET AL.: "Solubility limit and sites distribution of titanium in LaMgAl11O19:Ti<3+>, a potential tunable laser material" MATER. RES. BULL., Bd. 25, Nr. 4, 1990, Seiten 523-531, XP009007914

## Beschreibung

Gegenstand der Erfindung ist ein Wärmedämmmaterial mit im wesentlichen magnetoplumbitischer Kristallstruktur, ein Metallsubstrat mit einer Haftvermittler- sowie einer Wärmedämmschicht aus dem Wärmedämmmaterial auf seiner Oberfläche sowie ein Verfahren zur Beschichtung von Metallsubstraten mit dem Wärmedämmmaterial.

Wärmedammschichten werden in erster Linie bei den stationären Gasturbinen zur Energieerzeugung und in Fluggasturbinen eingesetzt. Diese Anwendungen stellen in immer höherem Maße erheblich gestiegene Anforderungen an die mechanischen und thermischen Eigenschaften der zum Einsatz kommenden Werkstoffe. Primäres Ziel dieser Entwicklung ist die Steigerung der Heißgastemperatur zur Erhöhung von Wirkungsgrad und Leistung bei einer gleichzeitigen Senkung des Triebstoffverbrauchs. Daneben soll erreicht werden, dass durch eine vollständigere Verbrennung des Treibstoffs bei höheren Temperaturen eine geringere Umweltbelastung durch Schadstoffe ermöglicht wird.

Um die Forderungen nach höheren Wirkungsgraden und somit geringerem Energieverbrauch zu erfüllen, müssen die Turbinen-Gaseintritttemperaturen zukünftig auf 1500°C gesteigert werden. Die höchstbeanspruchten Bauteile sind dabei die rotierenden Turbinenschaufeln, die in der Regel aus Nickel- und Cobalt-Superlegierungen bestehen. Da diese Legierungen einen Schmelzpunkt Tₛ zwischen 1250°C und 1320°C aufweisen und die Oberflächentemperatur beim Einsatz ca. 1000°C bis 1200°C betragen, werden diese Werkstoffe bereits bis 0.9 Tₛ eingesetzt. Die Lebensdauer dieser Werkstoffe wurden durch die Einführung der gerichtet erstarrten und einkristallinen Turbinenschaufeln und die Entwicklung immer aufwendigerer Film- und Innenkühlungen der Turbinenbauteile gesteigert. Dies verursacht jedoch Leistungsverluste durch die unwirtschaftliche Erhöhung der Kühlluftmenge. Damit ist man an die Grenzen der Werkstoffbelastung gekommen, die eine weitere Erhöhung der Gastemperatur mit den herkömmlichen Basiswerkstoffen nicht erlaubt.

Eine weitere Möglichkeit zur Steigerung der Heißgastemperatur besteht in der Beschichtung thermisch belasteter Turbinenbauteile mit einer thermisch isolierenden, keramischen Wärmedämmschicht. Durch das Aufbringen einer keramischen Deckschicht kann der Unterschied zwischen der Gastemperatur und der Temperatur des Turbinenwerkstoffes bei gleichbleibender Kühlluftmenge weiter erhöht werden. Zur Realisierung des Betriebs mit erhöhten Gastemperaturen müssen an das hierzu eingesetzte Material die grundlegenden Anforderungen, wie ein hoher Schmelzpunkt, ein niedriger Dampfdruck, eine hohe Phasenstabilität, eine niedrige Wärmeleitfähigkeit, ein möglichst hoher thermischer Ausdehnungskoeffizient, eine möglichst geringe Dichte, ein eingepasster Emissionsgrad für Infrarotstrahlung sowie ein hoher Thermoschock-, Oxidations- und Korrosionswiderstand gestellt werden. Alle diese Anforderungen zusammen genommen werden derzeit von keinem keramischen Werkstoff erfüllt. Als aussichtreichster Werkstoff hat sich das teilstabilisierte Zirkonoxid herausgestellt. Die Attraktivität von Zirkonoxid als Wärmedämmschicht ist in dem für keramische Werkstoffe relativ hohen thermischen Ausdehnungskoeffizienten (11 bis 13 x 10⁻⁶ K⁻¹), der guten Thermoschockbeständigkeit und der sehr geringen thermischen Leitfähigkeit (2 - 3W/mK) begründet.

Derzeitiger Stand der Technik in der Herstellung keramischer Wärmedämmschichten sind sogenannte Duplex-Systeme, die im Allgemeinen aus zwei verschiedenen Schichten bestehen. Zum Schichtsystem gehören eine keramische Deckschicht an der Oberfläche und eine metallische Haftvermittlerschicht (sogenannter Bond-Coat - BC), zur Verbesserung der Haftung der aufgebrachten Keramikschicht und zum weiteren Schutz der Basislegierung vor Oxidation und Heißgaskorrosion. Haftvermittlerschichten bestehen aus einer M-CrAIY-Legierung und/oder aus Aluminid. Im Einsatz oder auch schon bei der Herstellung der Schichten bildet sich an der Oberfläche des Bond-Coats eine dünne kontinuierliche Aluminiumoxidschicht, die aufgrund der geringen Sauerstoffdiffusion einen wirksamen Oxidationsschutz für das metallische Substrat darstellt und eine gute Haftung für die nachfolgende Keramikschicht vermittelt. Daher wird an die Haftvermittlerschicht ein komplexes Anforderungsprofil gestellt. Sie soll die inneren Spannungen aufgrund unterschiedlicher Wärmeausdehnungskoeffizienten abschwächen, Spannungsspitzen durch duktiles Werkstoffverhalten abbauen und eine dichte Oxidschicht ausbilden, wobei das aufwachsende Oxid thermomechanisch verträglich mit der darüber liegenden Wärmedämmschicht sein muss.

Die Herstellung solcher Duplex-Systeme ist durch verschiedener Verfahren möglich, hauptsächlich durch das Plasmaspritzen (PS), das CVD-Verfahren und das Elektronenstrahlverdampfen ((Electron Beam Physical Vapor Deposition)EB-PVD). Bei PS-Verfahren erhält man eine lamellare, plattenförmige Mikrostruktur mit hoher Porosität und Mikrorissigkeit. Diese Morphologie entsteht durch die Verformung und schnelle Erstarrung der geschmolzenen Partikel auf dem vergleichsweise kalten Substrat. Die Oberfläche der PS-Keramikschicht ist dementsprechend rau und erfordert eine Nachbearbeitung, um Strömungsverluste zu vermeiden. Ein weiterer Nachteil des Verfahrens liegt in der Verstopfung von Kühlluftbohrungen bei der Beschichtung, wodurch eine weitere Nachbearbeitung erforderlich ist. Die Vorteile des Verfahrens liegen in der Kostengünstigkeit und dem hohen Automatisierungsgrad.

Als weniger kostengünstige Verfahren stehen Hochvakuum-Verdampfungstechniken zur Verfügung, welche in qualitativ besseren Schichten resultieren. Die mittels EB-PVD hergestellten Wärmedämmschichten weisen eine kolumnare Mikrostruktur ebenfalls mit hohen Porosität auf. Durch eine verbesserte Dehnungstoleranz dieser kolumnaren Morphologie weisen die EB-PVD-Schichten eine längere Lebensdauer auf, denn diese Morphologie bewirkt eine außergewöhnliche Anpassungsfähigkeit der Schicht an mechanische Verformung und thermische Ausdehnung des metallischen Substrates.

Beim EB-PVD-Verfahren wird in einer Vakuumkammer ein feinfokussierter Elektronenstrahl mit programmierbaren Mustern über die zu verdampfende Keramik geführt, welche kontinuierlich von unten nachchargiert wird. Man erhält je nach Keramik eine 1 bis 30 mm tiefe Schmelze, die zwecks effektiverer Verdampfung überhitzt wird. In der Dampfwolke werden die vorgeheizten Bauteile oder Probekörper, beispielsweise Trubinenbauteile geeignet positioniert und/oder bewegt, so dass durch Abscheidung der Dampfteilchen an den Oberflächen ein stetiges Schichtwachstum stattfindet. Für Y₂O₃-teilstabilisiertes ZrO₂ (PYSZ) lassen sich ohne Probenrotation Aufdampfraten von 10-20 µm pro Minute erzielen. Bei Oxidkeramiken ist zur Erlangung der Stöchiometrie die Einleitung von Sauerstoff zumeist unerlässlich (reaktives Bedampfen), weshalb die Beschichtung bei Keramiken im Druckbereich zwischen 10⁻² bis 10⁻⁴ mbar erfolgt.

DE 198 07 163 C1 betrifft ein Wärmedämmmaterial und Verfahren zur Herstellung eines solchen. Es wird ein thermochemisch stabiles und phasenstabiles oxidisches Wärmedämmmaterial angegeben, das vorteilhaft als Wärmedämmschicht auf thermisch hochbelasteten Teilen, wie etwa Turbinenschaufeln oder dergleichen, angewendet werden kann. Das Wärmedämmmaterial kann durch Plasmaspritzen verarbeitet werden und besteht bevorzugt aus einer Magnetoplumbit-Phase im bevorzugten Zusammensetzungsbereich von MMeAl₁₁O₁₉, wobei M La oder Nd bedeutet und wobei Me aus den Erdalkalimetallen, Übergangsmetallen und den seltenen Erdalkalimetallen, vorzugsweise aus Magnesium, Zink, Cobalt, Mangan, Eisen, Nickel und Chrom ausgewählt ist. Magnesiumoxid-dotiere magnetoplumbitische Beschichtungen eignen sich nicht für das EB-PVD-Verfahren. Durch den externen Dampfdruck scheidet sich dieses Oxid bei viel zu niedrigen Temperaturen aus dem System aus und vernichtet die stöchiometrische Abscheidung. Eine kristalline Abscheidung dieser Phase benötigt eine Zusatzheizung, um das Substrat über die Kristalisationstemperatur (beispielsweise > 1000 °C) des Schichtmaterials zu erhitzen.

Die EP 0 812 930 A1 beschreibt thermische Verdampfermaterialien (Ingots) für die Beschichtung von Gegenständen mittels physikalischem Abscheiden aus der Gasphase. Neben der Herstellung und der Verwendung werden keramische Verdampfermaterialien beschrieben, die ein nicht gesintertes Gemisch wenigstens zweier Pulverfraktionen eines grobkörnigen und eines feinkörnigen Pulvers umfassen.

Die EP 0 890 559 A1 beschreibt ein Verfahren zur Beschichtung oxidischer Fasermaterialien mit Metallaluminaten zur Herstellung versagenstoleranter hochtemperaturfester oxidationsbeständiger Verbundwerkstoffe.

M.K. Cinibulk, J. M. Res., Vol. 14, Band 9, S. 3581 bis 3593, 1999 beschreibt die Wirkung von zweiwertigen Kationen, bei der Herstellung von Citratgel abgeleiteten Lanthanhexaluminatpulvern und Filmen. Unter anderem werden magnetoplumbitische Materialien der allgemeinen Formel **Ln**^{**3+**}**M**^{**2+**}_{**1+x**}**Q**_{**x**}^{**4+**}**Al**_{**11-2x**}**O**_{**19**}, untersucht. Es wird vorgeschlagen, mit diesem Material Faserbeschichtungen vorzunehmen.

Trotz des bisherigen Erfolges mit Zirkonoxid-Schichten bleibt die Hochtemperaturstabilität nur beschränkt erfüllt. Thermische Stabilität, d.h. keine Phasenumwandlung, keine Änderung von E-Modul und Mikrostruktur während des Einsatzes sind primäre Bedingungen. Außerdem wird das Gewicht als ein kritischer Faktor beim Design von rotierenden Gasturbinenkomponenten betrachtet. Keramische Wärmedämmschichten sind keine lasttragende Materialien und addieren zum Gewicht ohne Steigerung der Festigkeit. Deshalb sind solche Materialien, die wenig Gewicht aufbringen jedoch mehr zu thermischen Schutz beitragen, besonders erwünscht.

Ein erster Aspekt der Erfindung ist ein Metallsubstrat mit einer Wärmedämmschicht auf dem Metall-Substrat, wobei das Wärmedämmmaterial mit im wesentlichen magnetoplumbitischer Kristallstruktur einer chemischen Zusammensetzung der allgemeinen Formel

Ln³+M²⁺₁₊ₓQₓ⁴⁺Al₁₁₋₂ₓO₁₉,

wobei
Ln für ein Lanthanidenelement,
M für ein zweiwertiges Metallelement,
Q für ein vierwertiges Metallelement
mit der Maßgabe steht, dass 0 < x ≤ 1
aufweist.

In einer bevorzugten Ausführungsform der vorliegenden Erfindung ist das Metallsubstrat dadurch gekennzeichnet, dass das Lanthanidenlement ausgewählt ist aus La, Ce, Pr, Nd, Pm, Sm, Eu und/oder Gd.

Analog dazu ist vorzugsweise das zweiwertige Metallelement ausgewählt aus Mn, Fe, Co, Ni, Cu, Zn und/oder Sr.

Besonders bevorzugt im Sinne der vorliegenden Erfindung ist das vierwertige Metallelement ausgewählt aus Ti und/oder Si.

EB-PVD-hergestellte Wärmedämmschicht aus Mangan und Titanhaltigem La-hexaluminat, in dem Al teilweise durch Mn oder Co und Mn plus Ti-substituiert wurde, ist ein bevorzugtes Material und weist ein Potenzial zur Erhöhung des Verdichtungswiderstand hin. Die magnetoplumbitische Kristallstruktur dieses Materials ermöglicht die Ausbildung spaltbarer und stängelliger Körner innerhalb der Schichtkolumnen, was die Hochtemperatur-Stabilität der Wärmedämmschichten im Einsatz erhöht.

Die magnetoplumbitische Struktur ist hexagonal und besteht aus Spinell-ähnlichen Blöcken sowie Spiegelebenen, die diese Spinell-ähnliche Blöcke trennen. Spinell-ähnliche Blöcke beinhalten Al³⁺ und M²⁺ und Q⁴⁺-Kationen. La³⁺ dagegen befindet sich in der Spiegelebene mit den restlichen Al³⁺ Ionen. Der Einbau von 2- und 4-wertigen Kationen verdichtet den Spinell-ähnlichen Block und dadurch verbessert sich das Kristallisationsverhalten und der Homogenitätsbereich des magnetoplumbitischen La-hexaluminates. Die niedrigere Wärmeleitfähigkeit, der verhältnismäßig kleine E-Modul und die verdichtungsresistente Kristallstruktur dieses Materials sind die attraktivsten Gründe, warum LaMnAl₁₁O₁₉ als Wärmedämmschicht bestens angewendet werden kann.

Wärmedämmschichten unterliegen im Einsatz einem sehr komplexen Beanspruchungsprofil und sind daher einer Vielzahl von unterschiedlichen Schädigungsmechanismen ausgesetzt. Dies reduziert die Leistung und die Lebensdauer der Wärmedämmschicht und macht sich bemerkbar durch eine Änderung der Morphologie und daher auch der Materialeigenschaften bei höheren Temperaturen und über längere Zeiten. Die Schädigungsmechanismen führen zur Alterung und zum Versagen der Wärmedämmschichten in Form von mechanischen, thermomechanischen oder thermochemischen Prozessen z.B. Ermüdung, Oxidation, Rissbildung, Kriechen und Sintern. Die mikrostrukturelle Änderung der Wärmedämmschicht durch die Verdichtung bzw. Sintern resultiert in einer Reduktion der inter- und intrakolumnaren Porosität und in einer Vergröberung der Mikrostruktur in den Kolumnen. Dadurch erhöhen sich Elastizitätsmodul, thermische Leitfähigkeit und interne Spannungen.

Bei den EB-PVD-Schichten gemäß der vorliegenden Erfindung wurde gefunden, dass sich diese Eigenschaften weniger erhöhen als bei den PS-Schichten, jedoch wird durch die Verdichtung der kolumnaren Struktur die Dehnungstoleranz der Schicht reduziert.

Besonders bevorzugt im Sinne der vorliegenden Erfindung enthält das Wärmedämmmaterial einen Stoffmengenanteil an Ln, bezogen auf eingesetztes Ln₂O₃ von 1 bis 10 mol %

In gleicher Weise sind erfindungsgemäß Metallsubstrate mit Wärmedämmmaterialien besonders bevorzugt, wenn der Stoffmengenanteil an zweiwertigem Metallelement 0 bis 25 mol %, insbesondere 0,1 bis 25 mol %, besonders bevorzugt 1 bis 15 mol % beträgt.

In gleicher Weise sind erfindungsgemäße Metallsubstrate mit Wärmedämmmaterialien im Sinne der vorliegenden Erfindung besonders bevorzugt, wenn der Stoffmengenanteil an vierwertigem Metallelement 0 bis 5 mol %, insbesondere 0,1 bis 5 mol % beträgt. In diesem Sinne ist von Bedeutung, dass der Stoffmengenanteil an zweiwertigem Metallelement und vierwertigem Metallelement nicht gleichzeitig 0 sein kann, da in diesem Fall ein Lanthanhexaluminat beschrieben wird.

Wenn im Sinne der vorliegenden Erfindung davon die Rede ist, dass die Kristallstruktur im wesentlichen magnetoplumbitischer Natur sein soll, so wird hierunter eine Kristallstruktur verstanden, die wenigstens 80, insbesondere 90 Gew.-% des Wärmedämmmaterials beträgt.

Besonders bevorzugt im Sinne der vorliegenden Erfindung wird das Wärmedämmmaterial durch EB-PVD-Verfahren auf ein mit einer Haftvermittlerschicht beschichtetes Metallsubstrat aufgebracht.

Die Metallsubstrate bestehen vorzugsweise aus Nickel- oder Kobaltlegierungen. Diese können beispielsweise eingesetzt werden zur Herstellung von Heißgas-seitigen Gasturbinenelemente, insbesondere Turbinenschaufeln.

Wie im Stand der Technik üblich, kann auch erfindungsgemäß eine Haftvermittlerschicht, insbesondere aus M-CrAIY-Legierung und/oder aus Aluminid zwischen der Oberfläche des Metallsubstrats und des Wärmedämmmaterials angeordnet sein.

Ein weiterer Aspekt der vorliegenden Erfindung befasst sich mit einem Verfahren zur Beschichtung von Metallsubstraten mit einer Wärmedämmschicht auf der Oberfläche des mit einer Haftvermittlerschicht beschichteten Metallsubstrats mit einer besonderen Morphologie und Gefügestruktur. Dies beinhaltet einerseits die Herstellung des Ingots, beispielsweise in der EP 0 812 930 A1 durch ein chemisches Verfahren und andererseits die Aufbereitung der Wärmedämmschicht durch das EB-PVD-Verfahren.

Durch die günstigeren Eigenschaften, die in der unten gegebenen Tabelle aufgelistet sind, ist insbesondere Mn bzw. Mn+Ti-substituiertes magnetoplumbitisches Ln-hexaluminat ein sehr geeignetes Material für Wärmedämmungsanwendungen und bietet eine bessere Alternative gegenüber üblichen PYSZ-Schichten.

| Material | Wärmeleitfähigkeit (W/mK) | Ausdehnungskoeffizient (x 10 ⁻⁶ K ⁻¹) | E-Modul | Dichte (g/cm³) | Schmelzpunkt (°C) |
|---|---|---|---|---|---|
| LaMnMP* | λ_{RT} = 0.8-2.2 | 9.5 - 10.7 | 127 | 3.9 - 4.2 | 1930 |
| | λ₁₂₀₀ = 1.2 - 2.6 | | | | |
| YSPZ** | λ_{RT} = 0.6-1.8 | 10.8 - 11.6 | 242 | 5.95 | 2710 |
| | λ₁₂₀₀ = 2.2 - 2.4 | | | | |

| | | | | | |
|---|---|---|---|---|---|
| * erfindungsgemäß | | | | | |
| ** Vergleich | | | | | |

Mit Hilfe der erfindungsgemäßen Wärmedämmschichten ist eine höhere Wärmedämmung durch Materialeigenschaften der mehrstoffigen magnetoplumbitischen LnM₁₊ₓQₓAl₁₁₋₂ₓO₁₉-Schichten und durch ihre braune Färbung,

EB-PVD-Herstellung einer Wärmedämmschicht aus einem 4-Stoffsystemoxid durch Eintiegelverfahren und
Erreichung der höheren Homogenität im Dampfbad aber auch in der hochtemperaturresistenten EB-PVD-Schichten mittels chemisch hergestellter Ingots möglich.

### Ausführungsbeispiele:

### Beispiel 1: (Referenzbeispiel)

Präparation von LaMnAl₁₁O₁₉-EB-PVD-Beschichtungen, die aus γ-AL₂O₃₋Pulver und organisch/anorganisch-basierender Lösung vorbereitet sind:

Für 795 g LaMnAl₁₁O₁₉ -Pulver wurden folgende Herstellungsschritte durchgeführt.2000 ml einer 0.62 molaren Lösung von Lanthan-Acetaten in absolutem Äthanol wurden mit ca. 100 ml konzentrierter HNO₃ peptiziert. Dem Gemisch wurden 2000 ml Äthanol und 1 M Mn(NO₃)₂ wässrige Lösung zugefügt. Zu diesem klaren Sol wurde 705 g feines γ-AL₂O₃-Pulver unter ständigem Rühren zugegeben. Der pH-Wert der Mischung betrugt 6. Der Gelierungsprozess (Erstarrungsprozess) wurde unter kontinuierlichem Rühren mit Zugabe von ca.1000 ml H₂O/NH₃₋Mischung durchgeführt (pH=12). Für den Gelierungsprozess wurde eine Einwirkungszeit von ca. 10 Stunden verfügt. Der Alkohol des pulverisierten Gemisches wurde im Rotavapor verdampft und so das LaMnAl₁₁O₁₉-Precursor-Pulver gesammelt. 1/3 des Pulvers wurde bei 1500°C, 2/3 bei 1200°C kalziniert.

### Beispiel 2:

Präparation von LaMn_{0,5}Ti_{0,3}Al_{10,2}O₁₉ -EB-PVD-Beschichtungen, die aus organisch/anorganisch-basierender Lösungs-Gemische vorbereitet sind:

Für 500 g LaMn_{0,5}Ti_{0,3}Al_{10,2}O₁₉ wurden 1000 ml einer 0.32 molaren Lösung von Lanthan-Acetate (La(OOCCH₃)₃) in absoluten Äthanol wurden mit ca. 30 ml konzentrierter HNO₃ peptiziert. Dieser Lösung wurde eine 110 g 50%ige wässrige Mn(NO₃)₂ -Lösung zugefügt. 54 g Tiisopropoxid wurde mit 100 ml Äthanol gemischt und der Lösung beigemischt. Ein klares Sol wurde erhalten, zu dem 890gr Al-Sekbutoxid Al(OC₄H₉)₃ unter ständigem Rühren zugegeben wurde. Hierbei wurde eine leicht exotherme Reaktion beobachtet. Dieses Gemisch wurde mit destilliertem Wasser unter intensivem Rühren hydrolisiert.

Der Alkohol des pulverisierten Gemisches wurde im Rotavapor abgedampft und so das LaMn_{0,5}Ti_{0,3}Al_{10,2}O₁₉-Precursor-Pulver gewonnen. Das quasi-getrocknete Precusor-Pulver wurde im Trockenschrank bei 200°C weiter pyrolysiert. 1/3 des Pulvers wurde bei 1500°C, 2/3 bei 1200°C kalziniert.

### Beispiel 3:

### Ingot-Vorbereitung

Übliche Wachse (Bindemittel) (SS 1%, ST 1%, PEG 600 2%, EP 2%) wurden in aufgewärmtem Äthanol auflöst und dazu wurde die Pulvermischung in einen laufenden Ultraturrax gegeben.

Die Mischung aus Pulver und Bindemittel wurde im Rotavapor bei 80°C getrocknet und dann auf 500 µm gesiebt und schließlich granuliert.

Der Ingot von 63 mm Durchmesser und ca. 80 mm Höhe wurde in einer Stahl-Matrize gepresst. Anschließend wurde der Ingot in einer Kaltisostatischen Presse weiter verdichtet. Der Ingot wurde entsprechend den Abmessungen des Ingothalters der EB-PVD-Anlage auf Maß gedreht und zur Entfernung des Bindemittels ausgeheizt.

### Beispiel 4:

### Wärmedämmschicht-Beschichtung

Der gepresste und ausgegaste Ingot gemäß Beispiel 3 wurde in eine EB-PVD-Anlage eingesetzt. Beim EB-PVD-Verfahren wurde in einer Vakuumkammer ein feinfokussierter Elektronenstrahl mit einem definierten Muster über das zu verdampfende Keramik-Ingot geführt, welches kontinuierlich von unten nachchargiert wurde. Die notwendige Leistung zur Verdampfung war mit 30-60 kW vergleichbar mit den üblichen Werten von P-YSZ. Eine Schichtdicke von 1-10 µm pro Minute wurde erzielt. Das Beschichtungsverfahren wurde im Druckbereich zwischen 10⁻² bis 10⁻⁴ mbar auf vorgeheizten (ca. 800-1000°C) metallischen und/oder keramischen Substraten erfolgreich angewendet. Die erhaltenen Schichten waren braun, gut haftend und hatten einen kristallinen Aufbau.

## Patentansprüche

1. Metallsubstrat mit einer Wärmedämmschicht auf dem Metall-Substrat, wobei das Wärmedämmmaterial mit im wesentlichen magnetoplumbitischer Kristallstruktur einer chemischen Zusammensetzung der allgemeinen Formel
Ln³⁺M²⁺₁₊ₓQₓ⁴⁺Al₁₁₋₂ₓO₁₉,
wobei
Ln für ein Lanthanidenelement,
M für ein zweiwertiges Metallelement,
Q für ein vierwertiges Metallelement
mit der Maßgabe steht, dass 0 < x ≤ 1
aufweist.

2. Metallsubstrat nach Anspruch 1, **dadurch gekennzeichnet, dass** das Lanthanidenelement ausgewählt ist aus La, Ce, Pr, Nd, Pm, Sm, Eu und/oder Gd.

3. Metallsubstrat nach Anspruch 1 oder 2, **dadurch gekennzeichnet, dass** das zweiwertige Metallelement ausgewählt ist aus Mn, Fe, Co, Ni, Cu, Zn und/oder Sr.

4. Metallsubstrat nach einem der Ansprüche 1 bis 3, **dadurch gekennzeichnet, dass** das vierwertige Metallelement ausgewählt ist aus Ti und/oder Si.

5. Metallsubstrat nach einem der Ansprüche 1 bis 4, **dadurch gekennzeichnet, dass** der Stoffmengenanteil an Ln, bezogen auf eingesetztes Ln₂O₃ 1 bis 10 mol % beträgt.

6. Metallsubstrat nach einem der Ansprüche 1 bis 5, **dadurch gekennzeichnet, dass** der Stoffmengenanteil an zweiwertigem Metallelement MO 0 bis 25 mol %, insbesondere 1 bis 15 mol % beträgt.

7. Metallsubstrat nach einem der Ansprüche 1 bis 6, **dadurch gekennzeichnet, dass** der Stoffmengenanteil an vierwertigem Metallelement QO₂ bis 5 mol %, insbesondere 0,1 bis 5 mol % beträgt.

8. Metallsubstrat nach einem der Ansprüche 1 bis 7, **dadurch gekennzeichnet, dass** der Anteil an magnetoplumbitischer Kristallstruktur wenigstens 80, insbesondere 90 Gew. % beträgt.

9. Metallsubstrat nach einem der Ansprüche 1 bis 8, **dadurch gekennzeichnet, daß** die Wärmedämmschicht durch ein EB-PVD Verfahren hergestellt ist.

10. Metallsubstrat nach Anspruch 1-9 bestehend im wesentlichen aus Nickel- oder Cobalt-Superlegierungen.

11. Metallsubstrat nach Anspruch 10 bestehend aus heißgasseitigen Gasturbinenelementen, insbesondere Turbinenschaufeln.

12. Metallsubstrat nach einem der Ansprüche 1 bis 11 umfassend weiterhin eine Haftvermittlerschicht, insbesondere aus M-CrAIY-Legierung und/oder aus Aluminid zwischen der Oberfläche des Metallsubstrats und dem Wärmedämmmaterial.

13. Verfahren zur Herstellung von Metallsubstraten mit einer Wärmedämmschicht nach einem oder mehreren der Ansprüche 1 bis 12, **dadurch gekennzeichnet, dass** man das Wärmedämmmaterial mittels EB-PVD-Verfahren auf die gegebenenfalls mit einer Haftvermittlerschicht versehene Oberfläche des Metallsubstrats aufbringt.

## Claims

1. A metal substrate with a thermal-insulating layer on said metal substrate, wherein the thermal-insulating material with an essentially magnetoplumbitic crystal structure has a chemical composition of general formula
Ln³⁺M²⁺₁₊ₓQₓ⁴⁺Al₁₁₋₂ₓO₁₉
wherein
Ln represents a lanthanide element;
M represents a divalent metallic element;
Q represents a tetravalent metallic element;
with the proviso that 0 < x ≤ 1.

2. The metal substrate according to claim 1, **characterized in that** the lanthanide is chosen from La, Ce, Pr, Nd, Pm, Sm, Eu and/or Gd.

3. The metal substrate according to claim 1 or 2, **characterized in that** the divalent metal element is chosen from Mn, Fe, Co, Ni, Cu, Zn and/or Sr.

4. The metal substrate according to any of the claims 1 to 3, **characterized in that** the tetravalent metal element is chosen from Ti and/or Si.

5. The metal substrate according to any of the claims 1 to 4, **characterized in that** the mole fraction of Ln in relation to the charged Ln₂O₃ is 1 to 10 mole %.

6. The metal substrate according to any of the claims 1 to 5, **characterized in that** the mole fraction of the divalent metal element MO is 0 to 25 mole %, particularly 1 to 15 mole %.

7. The metal substrate according to any of the claims 1 to 6, **characterized in that** the mole fraction of the tetravalent metal element QO₂ is up to 5 mole %, particularly 0.1 to 5 mole %.

8. The metal substrate according to any of the claims 1 to 7, **characterized in that** the proportion of the magnetoplumbitic crystal structure is at least 80 per cent by weight, particularly 90 per cent by weight.

9. The metal substrate according to any of the claims 1 to 8, **characterized in that** the thermal-insulation layer is produced by an EB-PVD process.

10. The metal substrate according to claims to 9, which is essentially consisting of nickel or cobalt superalloys.

11. The metal substrate according to claim 10, which consists of gas turbine elements arranged on the hot gas side, particularly of turbine buckets.

12. The metal substrate according to any of claims 1 to 11, further comprising an adhesive layer, particularly made of an M-CrAlY alloy and/or of aluminide, between the surface of the metal substrate and the thermal-insulating material.

13. A process for the production of metal substrates having a thermal-insulating layer according to one or more of the claims 1 to 12, **characterized in that** the thermal-insulating material is applied by means of the EB-PVD process onto the surface - which, if necessary, is provided with an adhesive layer - of the metal substrate.

## Revendications

1. Substrat métallique muni d'une couche d'isolation thermique placée sur le substrat métallique, dans lequel le matériau isolant thermique présente une structure cristalline qui est essentiellement de type magnétoplombite et une composition chimique qui correspond à la formule générale suivante :
Ln³⁺M²⁺₁₊ₓQ⁴⁺ₓAl₁₁₋₂ₓO₁₉
dans laquelle :
- Ln représente un élément lanthanide,
- M représente un élément métallique divalent,
- Q représente un élément métallique tétravalent,
- et x représente un nombre défini par les inégalités 0 < x ≤ 1.

2. Substrat métallique conforme à la revendication 1, **caractérisé en ce que** l'élément lanthanide est choisi parmi les lanthane, cérium, praséodyme, néodyme, promethium, samarium, europium et/ou gadolinium.

3. Substrat métallique conforme à la revendication 1 ou 2, **caractérisé en ce que** l'élément métallique divalent est choisi parmi les manganèse, fer, cobalt, nickel, cuivre, zinc et/ou strontium.

4. Substrat métallique conforme à l'une des revendications 1 à 3, **caractérisé en ce que** l'élément métallique tétravalent est choisi parmi le titane et/ou le silicium.

5. Substrat métallique conforme à l'une des revendications 1 à 4, **caractérisé en ce que** la proportion d'élément(s) lanthanide(s) Ln, calculée en Ln₂O₃, vaut de 1 à 10 % en moles.

6. Substrat métallique conforme à l'une des revendications 1 à 5, **caractérisé en ce que** la proportion d'élément(s) métalliques(s) divalent(s), calculée en MO, vaut de 0 à 25 % en moles, et en particulier de 1 à 15 % en moles.

7. Substrat métallique conforme à l'une des revendications 1 à 6, **caractérisé en ce que** la proportion d'élément(s) métalliques(s) tétravalent(s), calculée en QO₂, vaut jusqu'à 5 % en moles, et en particulier de 0,1 à 5 % en moles.

8. Substrat métallique conforme à l'une des revendications 1 à 7, **caractérisé en ce que** la fraction de matériau de structure cristalline de type magnétoplombite vaut au moins 80 %, et en particulier 90 % en poids.

9. Substrat métallique conforme à l'une des revendications 1 à 8, **caractérisé en ce que** la couche d'isolation thermique est produite par un procédé EB-PVD (dépôt physique à partir de vapeur, assisté par faisceau électronique).

10. Substrat métallique conforme à l'une des revendications 1 à 9, essentiellement constitué d'un superalliage à base de nickel ou de cobalt.

11. Substrat métallique conforme à la revendication 10, constituant des éléments de turbine à gaz pour côté gaz chaud, en particulier des aubes de turbine.

12. Substrat métallique conforme à l'une des revendications 1 à 11, comprenant en outre une couche d'adhésion, en particulier en un alliage M-CrAlY et/ou en aluminure, placée entre la surface du substrat métallique et le matériau isolant thermique.

13. Procédé de fabrication d'un substrat métallique muni d'une couche d'isolation thermique, conforme à l'une ou plusieurs des revendications 1 à 12, **caractérisé en ce que** l'on dépose le matériau isolant thermique, selon un procédé EB-PVD, sur la surface du substrat métallique, éventuellement munie d'une couche d'adhésion.
